# EUROPEAN PATENT APPLICATION

(11) **EP 2 079 289 A2**
(43) Date of publication of application: **15.07.2009**
(21) Application number: 08171766.2
(22) Date of filing: 16.12.2008
(51) Int. Cl.: H05K 1/03, H05K 1/02, H01L 23/14, H01L 23/66

(54) **Printed wiring board and printed substrate unit**

(30) Priority: 08.01.2008 JP 2008001507
(71) Applicant: Fujitsu Limited, Kawasaki-shi, Kanagawa 211-8588 (JP)
(72) Inventor: Morita, Yoshihiro, Kawasaki-shi, Kanagawa 211-8588 (JP)
(74) Representative: Stebbing, Timothy Charles

(57) **Abstract**

A printed wiring board includes a main body (23), a plurality of glass fiber yarns (24, 26, 27) disposed in parallel with each other with a predetermined width, a pair of first wirings (16) disposed in parallel with the glass fiber yarns, a pair of second wirings (17) disposed in parallel with the glass fiber yarns, and a pair of connection wirings for connecting the first and the second wiring while being orthogonal to the glass fiber yarns, wherein the glass fiber yarns are separated at the same space as the width of the glass fiber yarns, and the center line of the first wiring and the second wiring are separated at a space of (space between the center lines of the adjacent glass fiber yarns × 1/2 + space between the center lines of the adjacent glass fiber yarns × N (N is an integer of at least 0 (zero)).

## Description

This application is based upon and claims the benefit of priority of the prior Japanese Patent Application No. 2008-1507, filed on January 8, 2008.

The present invention relates to a printed wiring board used for, for example, differential signal transmission.

A relay apparatus is used to construct, for example, a backbone communication network. A printed substrate unit is assembled on the relay apparatus. A plurality of LSI (large scale integrated circuit) chips are mounted on a front surface of a printed wiring board in the printed substrate unit. The LSI chips are connected to each other by, for example, a pair of wiring patterns extending in the printed wiring board. The wiring patterns are separated from each other by predetermined spaces. Differential signal transmission is realized between the LSI chips.

The printed wiring board is composed of resin along with a yarn or cloth such as one made of glass fiber. The glass fiber yarn or cloth is impregnated with the resin. For example, the glass fiber is woven into a cloth having warps and wefts. The wiring patterns described above extend in parallel with, for example, the warps. Predetermined spaces are partitioned between the warps. The spaces are filled with the resin. When, for example, one wiring pattern coincides with a space, i.e. with the resin in a relatively large area, the other wiring pattern coincides with the warps in the relatively large area.

Patent Document 1: Japanese Laid-open Patent Publication No. 2003-218271.

Patent Document 2: Japanese Laid-open Patent Publication No. H10-117048.

Patent Document 3: Japanese Laid-open Patent Publication No. 2006-100699.

The resin and glass fiber yarn have different dielectric constants. As a result, characteristic impedance is dispersed between one wiring pattern and the other wiring pattern depending on whether the resin and the glass which coincide with each other have a large area or not. Thus, a differential signal has a different transmission speed. When, for example, a signal is transmitted based on a differential voltage, the difference of the transmission speed causes a time lag of a voltage change in an LSI chip on a receiving side. As a result, the signal cannot be accurately transmitted.

In view of the above actual circumstances, it is desirable to provide a printed wiring board and a printed substrate unit capable of suppressing an influence of a dielectric constant by a simple structure.
According to a first aspect of the present invention, there is provided a printed wiring board comprising:
a main body made of resin;
a plurality of yarns which are woven, impregnated with resin of the main body, and disposed in parallel with each other with a predetermined width;
a pair of first wirings formed on a front surface of the main body and disposed in parallel with the yarns;
a pair of second wirings formed on a front surface of the main body, disposed in parallel with the yarns, and having the same length as the length of the first wirings corresponding thereto, respectively; and
a pair of connection wirings for individually connecting the first wiring and the second wiring corresponding thereto while being orthogonal to the yarns,
wherein the yarns adjacent to each other are separated at the same space as the width of the yarns; and the center line of the first wiring and the center line of the second wiring corresponding thereto are separated at a space of (space between the center lines of the adjacent yarns x 1/2 + space between the center lines of the adjacent yarns x N (N is an integer of at least 0 (zero)).

Reference is made, by way of example only, to the accompanying drawings in which:
FIG. 1 is a perspective view schematically showing a structure of a specific example of electronic equipment, i.e. a transmission apparatus;
FIG. 2 is a perspective view schematically showing a structure of a printed substrate unit according to the specific example;
FIG. 3 is a partial vertical sectional view taken along a line 3-3 of FIG. 2;
FIG. 4 is a sectional view taken along a line 4-4 of FIG. 3;
FIG. 5 is a view schematically showing a structure of a printed wiring board according to a first embodiment;
FIG. 6 is a sectional view schematically showing a structure of a wiring pattern;
FIG. 7 is a view schematically showing a structure of a printed wiring board according to a second embodiment;
FIG. 8 is a view schematically showing a structure of a printed wiring board according to a third embodiment;
FIG. 9 is a sectional view schematically showing a structure of a wiring pattern; and
FIG. 10 is a sectional view schematically showing a structure of a wiring pattern.

In the accompanying drawings, like reference numerals refer to like elements throughout.

An embodiment will be explained referring to the accompanying drawings.

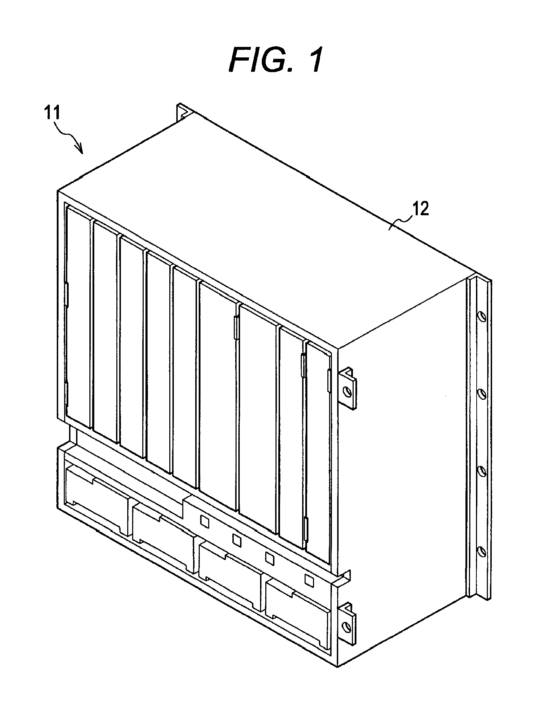

FIG. 1 is a perspective view schematically showing a structure of a specific example of electronic equipment, i.e. a transmission apparatus 11. The transmission apparatus 11 is assembled with, for example, a dense wavelength division multiplexing (DWDM) communication system. The transmission apparatus 11 is mounted on, for example, a rack. The transmission apparatus 11 has a housing 12. A printed substrate unit embodying the present invention, i.e. a mother board is assembled in an accommodation space of the housing 12.

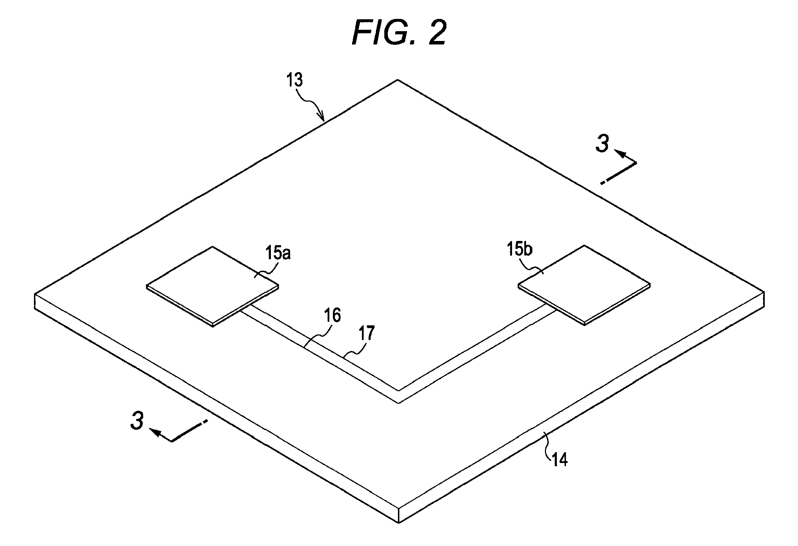

FIG. 2 schematically shows a structure of the mother board 13 according to the embodiment. The mother board 13 has, for example, a large printed wiring board 14. A pair of electronic parts, i.e. a first LSI (large scale integrated circuit) chip package 15a and a second LSI chip package 15b, for example, is mounted on a front surface of the printed wiring board 14. The first and second LSI chip packages 15a, 15b are fixed to the printed wiring board 14 by, for example, a ball grid array (BGA).

The first LSI chip package 15a and the second LSI chip package 15b are individually connected electrically by, for example, a first linear wiring pattern 16 and a second linear wiring pattern 17. With this arrangement, differential signal transmission is established between the first LSI chip package 15a and the second LSI chip package 15b based on, for example, a differential voltage. The first and second wiring patterns 16, 17 are disposed in parallel with each other in, for example, the printed wiring board 14. The first and second wiring patterns 16, 17 are bent at right angles.

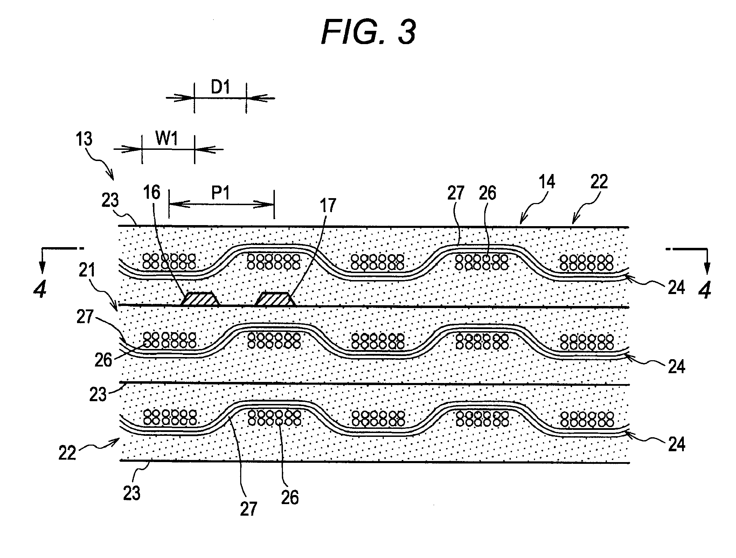

FIG. 3 schematically shows a structure of the printed wiring board 14 according to a first embodiment. The printed wiring board 14 has core resin layers 21 and insulation layers 22 formed on front surfaces and back surfaces of the core resin layers 21. The core resin layers 21 and the insulation layers 22 have resin main bodies 23. The main bodies 23 are made of, for example, epoxy resin. The core resin layers 21 have such a degree of rigidity that they maintain their shapes by themselves. The core resin layer 21 and the insulation layers 22 have a thickness of, for example, about 100 µm to 200 µm, respectively.

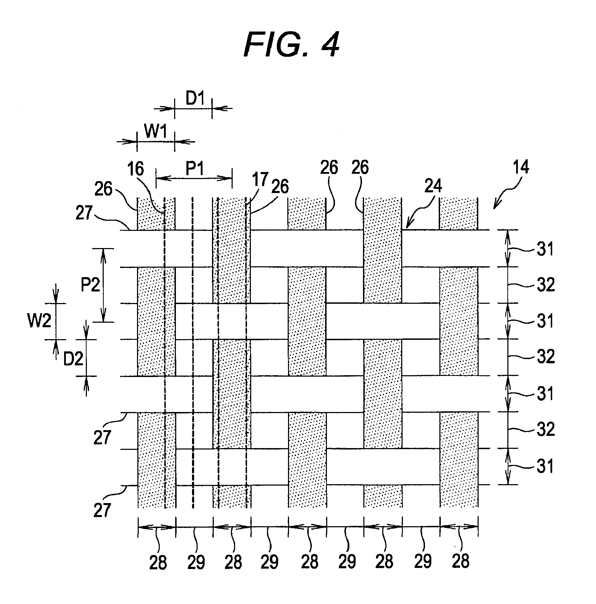

Glass fiber cloth 24 is embedded in the main bodies 23. The glass fiber cloth 24 has a thickness of, for example, about 30 µm. Referring to also FIG. 4, the glass fiber cloth 24 is woven from a plurality of warps 26 and a plurality of wefts 27. The plurality of warps 26 are mutually disposed in parallel with each other, and the plurality of wefts 27 are mutually disposed in parallel with each other. Here, the warps 26 and wefts 27 are disposed orthogonally to each other. The warps 26 are disposed with equal spaces with each other. Likewise, the wefts 27 are disposed with equal spaces with each other.

The warps 26 and wefts 27 are composed of glass fiber yarns. Here, each warp 26 and weft 27 is composed of a bundle of a plurality of glass fibers. However, each warp 26 and weft 27 may be composed of one glass fiber. It is sufficient to impregnate the glass fiber cloth 24 with resin when the core resin layers 21 and the insulation layers 22 described above are formed.

The width W1 of the warps 26 and the width W2 of the wefts 27 are made the same width. The space D1 of warps 26, which are located adjacent to each other, is made the same as the width W1 of the warps 26. Likewise, the space D2 of wefts 27, which are located adjacent to each other, is made the same as the width W2 of the wefts 27. Accordingly, the space P1 between the center lines of adjacent warps 26, which extend in parallel with each other, is made twice the width W1 and the space D1, respectively. Likewise, the space P2 between the center lines of adjacent wefts 27, which extend in parallel with each other, is made twice the width W2 and the space D2, respectively. The space P1 is made the same as the space P2. The space P1 and the space P2 are made uniform between the core resin layers 21 and the insulation layers 22.

As apparent from FIG. 4, a relatively large amount of glass fibers is contained in first regions 28 containing the warps 26 in the printed wiring board 14. The width of the first regions 28 is prescribed by the width W1 of the warps 26. Second regions 29 are located adjacent to the first regions 28. The second regions 29 are prescribed by the space between adjacent warps 26. That is, the width of the second regions 29 is prescribed by the space D1. Since no warps 26 are disposed in the second regions 29, a relatively large amount of resin is contained in the second regions 29. First and second regions 28, 29 are alternately partitioned.

Likewise, a relatively large amount of glass fibers is contained in first regions 31 containing the wefts 27 in the printed wiring board 14. The width of the first regions 31 is prescribed by the width W2 of the wefts 27. Second regions 32 are located adjacent to the first regions 31. The second regions 32 are prescribed by the space between adjacent wefts 27. That is, the width of the second regions 32 is prescribed by the space D2. Since no wefts 27 are disposed in the second regions 32, a relatively large amount of resin is contained in the second regions 32. First regions 31 and second regions 32 are alternately partitioned.

For example, the first and second wiring patterns 16, 17 described above are formed on a front surface of the core resin layer 21. The first and second wiring patterns 16, 17 are formed of a conductive material, for example, copper. The width of the first and second wiring patterns 16, 17 is made, for example, about 100 µm. The first wiring pattern 16 and the second wiring pattern 17 extend in parallel with the warps 26. Since the first and second wiring patterns 16, 17 are bent at right angles, they also extend in parallel with the wefts 27.

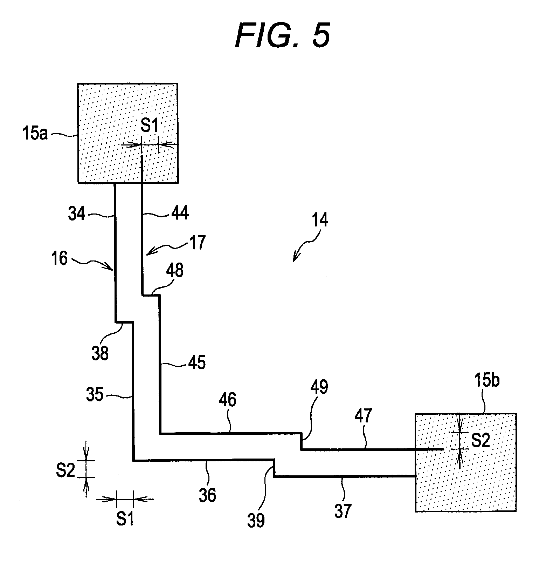

As shown in FIG. 5, the first wiring pattern 16 has a first wiring 34 to a fourth wiring 37. The first and second wiring patterns 34, 35 extend in parallel with the warps 26. The first LSI chip package 15a is connected to one end of the first wiring 34. The length of the first wiring 34 is made the same as the length of the second wiring 35. The other end of the second wiring 35 is connected to one end of the third wiring 36. The third and fourth wirings 36, 37 extend in parallel with the wefts 27. The length of the third wiring 36 is made the same as the length of the fourth wiring 37. The second LSI chip package 15b is connected to the other end of the fourth wiring 37.

The other end of the first wiring 34 and one end of the second wiring 35 are connected by a first connection wiring 38. The first connection wiring 38 extends in parallel with the wefts 27. That is, the first connection wiring 38 extends in a direction orthogonal to the warps 26. The other end of the third wiring 36 and one end of the fourth wiring 37 are connected by a second connection wiring 39. The second connection wiring 39 extends in parallel with the warps 26. That is, the second connection wiring 39 extends in a direction orthogonal to the wefts 27.

Likewise, the second wiring pattern 17 has a first wiring 44 to a fourth wiring 47. The first and second wirings 44, 45 extend in parallel with the warps 26. The first LSI chip package 15a is connected to one end of the first wiring 44. The length of the first wiring 44 is set to the same as the length of the second wiring 45. The other end of the second wiring 45 is connected to one end of the third wiring 46. The third and fourth wirings 46, 47 extend in parallel with the wefts 27. The length of the third wiring 46 is made the same as the length of the fourth wiring 47. The second LSI chip package 15b is connected to the other end of the fourth wiring 47.

The other end of the first wiring 44 and one end of the second wiring 45 are connected by a first connection wiring 48. The first connection wiring 48 extends in parallel with the wefts 27. That is, the first connection wiring 48 extends in a direction orthogonal to the warps 26. The other end of the third wiring 46 and one end of the fourth wiring 47 are connected by a second connection wiring 49. The second connection wiring 49 extends in parallel with the warps 26. That is, the second connection wiring 49 extends in a direction orthogonal to the wefts 27.

The length of the first wiring 16 is made the same as the length of the second wiring 17. Accordingly, it is sufficient to make the lengths of the first and second wirings 34, 35 the same as the lengths of the first and second wirings 44, 45 between the first and second wiring patterns 16, 17. It is sufficient for the first connection wirings 38, 48 to have the same length. Likewise, it is sufficient to make the lengths of the third and fourth wirings 36, 37 the same as the lengths of the third and fourth wirings 46, 47. It is sufficient for the second connection wirings 39, 49 to have the same length.

In the first wiring pattern 16, the center line of the first wiring 34 is separated from the center line of the second wiring 35 corresponding thereto by a space S1 of (space P1 x 1/2 + space P1 x N). N is set to an integer of at least 0 (zero). Here, N = 0, that is, the space S1 is set to one half the space P1. Likewise, the center line of the third wiring 36 is separated from the center line of the fourth wiring 37 corresponding thereto by a space S2 of (space P2 x 1/2 + space P2 x N). N is set to an integer of at least 0 (zero). Here, N = 0, that is, the space S2 is set to one half the space P2.

In the second wiring pattern 17, the center line of the first wiring 44 is separated from the center line of the second wiring 45 corresponding thereto by a space S1 of (space P1 x 1/2 + space P1 x N). N is set to an integer of at least 0 (zero). Here, N = 0, that is, the space S1 is set to one half the space P1. Likewise, the center line of the third wiring 46 is separated from the center line of the fourth wiring 47 corresponding thereto by a space S2 of (space P2 x 1/2 + space P2 x N). N is set to an integer of at least 0 (zero). Here, N = 0, that is, the space S2 is set to one half the space P2. Here, the space S1 agrees with the space S2.

The printed wiring board 14 has a pair of the first wirings 34, 44 and a pair of the second wirings 35, 45, i.e. even pairs of wirings which extend in parallel with the warps 26. At the same time, the printed wiring board 14 has a pair of the first connection wirings 38, 48, i.e. odd pairs of connection wirings. Likewise, the printed wiring board 14 has a pair of the third wirings 36, 46 and a pair of the fourth wirings 37, 47, i.e.: even pairs of wirings which extend in parallel with the wefts 27. At the same time, the printed wiring board 14 has a pair of the second connection wirings 39, 49, i.e. odd pairs of connection wirings.

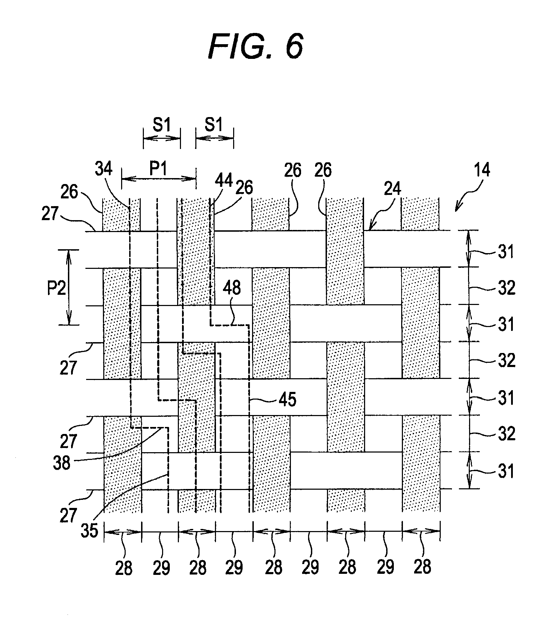

As shown in FIG. 6, in the first wiring pattern 16, the ratio of the first wiring 34 (the third wiring 36) disposed in the first region 28 (the first region 31) and the second region 29 (second region 32) is prescribed exactly opposite to the ratio of the second wiring 35 (the fourth wiring 37) disposed in the first region 28 (the first region 31) and the second region 29 (second region 32). Since the first wiring 34 (the third wiring 36) and the second wiring 35 (the fourth wiring 37) have the same length, the ratios of the glass fiber and the resin covered to the first wiring 34 (the third wiring 36) are set exactly opposite to the ratios of the glass fiber and the resin covered to the second wiring 35 (the fourth wiring 37). Accordingly, in the first wiring pattern 16, a dielectric constant is set to the same value.

Likewise, in the second wiring pattern 17, the ratio of the first wiring 44 (the third wiring 46) disposed in the first region 28 (the first region 31) and the second region 29 (second region 32) is prescribed exactly opposite to the ratio of the second wiring 45 (the fourth wiring 47) disposed in the first region 28 (the first regions 31) and the second region 29 (second region 32). Since the first wiring 44 (the third wiring 46) and the second wiring 45 (the fourth wiring 47) have the same length, the ratios of the glass fiber and the resin covered to the first wiring 44 (the third wiring 46) are set exactly opposite to the ratios of the glass fiber and the resin covered to the second wiring 45 (the fourth wiring 47). Accordingly, in the second wiring pattern 17, a dielectric constant is set to the same value.

In the mother board 13 as described above, even if the first and second wiring patterns 16, 17 are disposed at any positions on the main body 23, an influence due to the difference between the dielectric constant of the glass fiber and the dielectric constant of the resin is cancelled in the first and second wiring patterns 16, 17 over the entire lengths thereof. The dispersion of characteristic impedance is securely avoided between the first and second wiring patterns 16, 17. The difference of a transmission speed is securely avoided between the first and second wiring patterns 16, 17. The differential signal can be correctly transmitted. Note that even if N described above is set to an integer of at least one, a similar operation/working effect is realized.

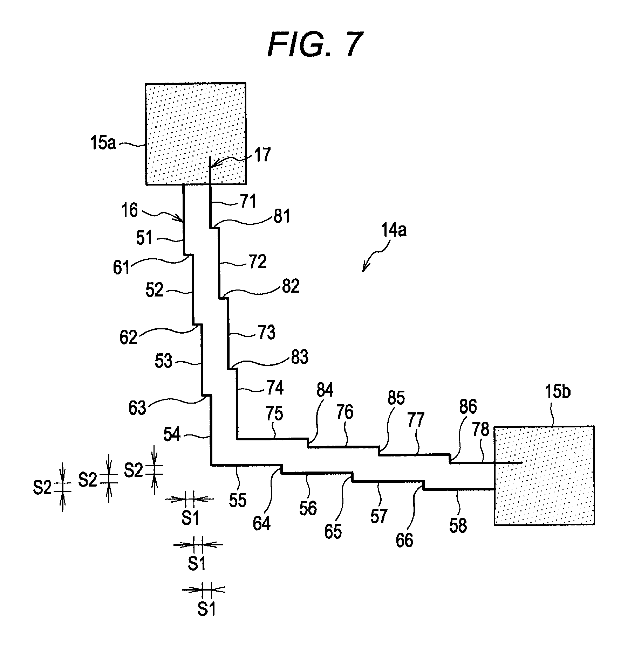

FIG. 7 schematically shows a structure of a printed wiring board 14a according to a second embodiment. In the printed wiring board 14a, the number of wirings and connection wirings increase as compared with that of the printed wiring board 14 described above. A first wiring pattern 16 has a first wiring 51 to a fourth wiring 54 extending in parallel with warps 26 and a fifth wiring 55 to an eighth wiring 58 extending in parallel with wefts 27. The first wiring 51 is connected to a first LSI chip package 15a. The fourth wiring 54 is connected to the fifth wirings 55. The eighth wiring 58 is connected to a second LSI chip package 15b.

The first and second wirings 51, 52, the second and third wirings 52, 53 as well as the third and fourth wirings 53, 54 are connected by a first connection wiring 61 to a third connection wiring 63, respectively. The first wiring 61 to the third wiring 63 extend in parallel with the wefts 27. In contrast, the fifth and sixth wirings 55, 56, the sixth and seventh wirings 56, 57 as well as the seventh and eighth wirings 57, 58 are connected by a fourth connection wiring 64 to a sixth connection wiring 66, respectively. The fourth wiring 64 to the sixth wiring 66 extend in parallel with the warps 26.

The sum of the lengths of all the s-th wirings (s is an odd number of at least 1) extending in parallel with the warps 26 is set equal to the sum of the lengths of all the t-th wirings (t is an even number of at least two) extending in parallel with the warps 26. Accordingly, the sum of the lengths of the first and third wirings 51, 53 is set equal to the sum of the lengths of the second and fourth wirings 52, 54. Likewise, the sum of the lengths of all the s-th wirings (s is an odd number of at least 1) extending in parallel with the wefts 27 is set equal to the sum of the lengths of all the t-th wirings (t is an even number of at least two) extending in parallel with the wefts 27. Accordingly, the sum of the lengths of the fifth and seventh wirings 55, 57 is set equal to the sum of the lengths of the sixth and eighth wiring 56, 58.

The center line of an r-th wiring (r is an integer of at least 1) is separated from the center line of an (r+1)-th wiring by a space S1 of (space P1 x 1/2 + space P1 x N). N is set to an integer of at least 0 (zero). Here, N = 0, that is, the space S1 is set to one half the space P1. That is, all of the space between the center lines of the first and second wirings 51, 52, the space between the center lines of the second and third wirings 52, 53, and the space between the center lines of the third and fourth wirings 53, 54 are set to the space S1.

Likewise, the center line of the r-th wiring (r is an integer of at least 1) is separated from the center line of the (r+1)-th wiring by a space S2 of (space P1 x 1/2 + space P1 x N). N is set to an integer of at least 0 (zero). Here, N = 0, that is, the space S2 is set to one half the space P2. Here, the space S2 agrees with the space S1. That is, all of the space between the center lines of the fifth and sixth wirings 55, 56, the space between the center lines of the sixth and seventh wirings 56, 57, and the space between the center lines of the seventh and eighth wirings 57, 58 are set to the space S2.

In contrast, the second wiring pattern 17 is arranged likewise the first wiring pattern 16. The second wiring pattern 17 has a first wiring 71 to a fourth wiring 74 extending in parallel with the warps 26 and a fifth wiring 75 to an eighth wiring 78 extending in parallel with the wefts 27. The first wiring 71 is connected to the first LSI chip package 15a. The fourth wiring 74 is connected to the fifth wirings 75. The eighth wiring 78 is connected to the second LSI chip package 15b.

The first and second wirings 71, 72, the second and third wirings 72, 73, as well as the third and fourth wirings 73, 74 are connected by a first connection wiring 81 to a third connection wiring 83, respectively. The first connection wiring 81 to the third connection wiring 83 extend in parallel with the wefts 27. In contrast, the fifth and sixth wirings 75, 76, the sixth and seventh wirings 76, 77 as well as the seventh and eighth wirings 77, 78 are connected by a fourth connection wiring 84 to a sixth connection wiring 86, respectively. The fourth connection wiring 84 to the sixth connection wiring 86 extend in parallel with the warps 26.

The sum of the lengths of all the s-th wirings (s is an odd number of at least 1) extending in parallel with the warps 26 is set equal to the sum of the lengths of all the t-th wirings (t is an even number of at least two) extending in parallel with the warps 26. Accordingly, the sum of the lengths of the first and third wirings 71, 73 is set equal to the sum of the lengths of the second and fourth wirings 72, 74. Likewise, the sum of the lengths of all the s-th wirings (s is an odd number of at least 1) extending in parallel with the wefts 27 is set equal to the sum of the lengths of all the t-th wirings (t is an even number of at least two) extending in parallel with the wefts 27. Accordingly, the sum of the lengths of the fifth and seventh wirings 75, 77 is set equal to the sum of the lengths of the sixth and eighth wiring 76, 78.

The center line of the r-th wiring (r is an integer of at least 1) is separated from the center line of the (r+1)-th wiring by the space S1 of (space P1 x 1/2 + space P1 x N). N is set to an integer of at least 0 (zero). Here, N = 0, that is, the space S1 is set to one half the space P1. That is, all of the space between the center lines of the first and second wiring 71, 72, the space between the center lines of the second and third wirings 72, 73, and the space between the center lines of the third and fourth wiring 73, 74 are set to the space S1.

Likewise, the center line of the r-th wiring (r is an integer of at least 1) is separated from the center line of the (r+1)-th wiring by the space S2 of (space P2 x 1/2 + space P2 x N). N is set to an integer of at least 0 (zero). Here, N = 0, that is, the space S2 is set to one half the space P2. That is, all of the space between the center lines of the fifth and sixth wirings 75, 76, the space between the center lines of the sixth and seventh wirings 76, 77, and the space between the center lines of the seventh and eighth wirings 77, 78 are set to the space S2.

The printed wiring board 14a arranged as described above has a pair of the first wirings 51, 71, a pair of the second wirings 52, 72, a pair of the third wiring 53, 73, and a pair of the fourth wiring 54, 74 extending in parallel with the warps 26a, that is, even pairs of the wirings. At the same time, the printed wiring board 14a has a pair of the first connection wiring 61, 81, a pair of the second connection wiring 62, 82, and a pair of the third connection wirings 63, 83, that is, odd pairs of the connection wirings. Likewise, the printed wiring board 14a has a pair of the fourth wiring 54, 74, a pair of the fifth wirings 55, 75, a pair of the sixth wirings 56, 76, and a pair of the fourth wiring 57, 77 extending in parallel with the wefts 27, that is, even pairs of the wirings. At the same time, the printed wiring board 14a has a pair of the fourth connection wiring 64, 84, a pair of the fifth connection wiring 65, 85, and a pair of the sixth connection wirings 66, 86, that is, odd pairs of the connection wirings. In addition to the above-mentioned, an arrangement and a structure that are the same as those of the printed wiring board 14 described above are denoted by the same reference numerals.

In the first wiring pattern 16, the sum of the lengths of the first and third wiring 51, 53 is set equal to the sum of the lengths of the second and fourth wirings 52, 54. At the same time, in the first wiring pattern 16, the ratio of the first wiring 51 (the fifth wiring 55) and the third wiring 53 (the seventh wiring 57) disposed in the first region 28 (the first region 31) and the second region 29 (the second region 32) is prescribed exactly opposite to the ratio of the second wiring 52 (the sixth wiring 56) and the fourth wiring 54 (the eighth wirings 58) disposed in the first region 28 (the first region 31) and the second region 29 (the second region 32). The ratios of glass fiber and resin covered to the first wiring 51 (the fifth wiring 55) and the third wiring 53 (the seventh wiring 57) are set exactly opposite to the ratios of glass fiber and resin covered to the second wiring 52 (the sixth wiring 56) and the fourth wiring 54 (eighth wiring 58). Accordingly, in the first wiring pattern 16, a dielectric constant is set to the same value.

Likewise, in the second wiring pattern 17, the sum of the lengths of the first and third wirings 71, 73 is set equal to the sum of the lengths of the second and fourth wirings 72, 74. At the same time, in the second wiring pattern 17, the ratio of the first wiring 71 (the fifth wirings 75) and the third wiring 73 (the seventh wiring 77) disposed in the first region 28 (the first regions 31) and the second region 29 (the second region 32) is prescribed exactly opposite to the ratio of the second wiring 72 (sixth wiring 76) and the fourth wiring 74 (the eighth wiring 78) disposed in the first region 28 (the first regions 31) and the second region 29 (the second region 32). The ratios of glass fiber and resin covered to the first wiring 71 (the fifth wiring 75) and the third wiring 73 (the seventh wiring 77) are set exactly opposite to the ratios of glass fiber and resin covered to the second wiring 72 (the sixth wiring 76) and the fourth wiring 74 (the eighth wiring 78). Accordingly, in the second wiring pattern 17, a dielectric constant is set to the same value.

In the printed wiring board 14a as described above, even if the first and second wiring patterns 16, 17 are disposed at any positions on a main body 23, the influence due to the difference between the dielectric constant of the glass fiber and the dielectric constant of the resin is cancelled in the first and second wiring patterns 16, 17 over the entire lengths thereof. The dispersion of characteristic impedance is securely avoided between the first and second wiring patterns 16, 17. The disagreement of a transmission speed between the first and second wiring patterns 16, 17 is securely avoided. A differential signal can be correctly transmitted. Note that even if N described above is set to an integer of at least one, a similar operation/working effect is realized.

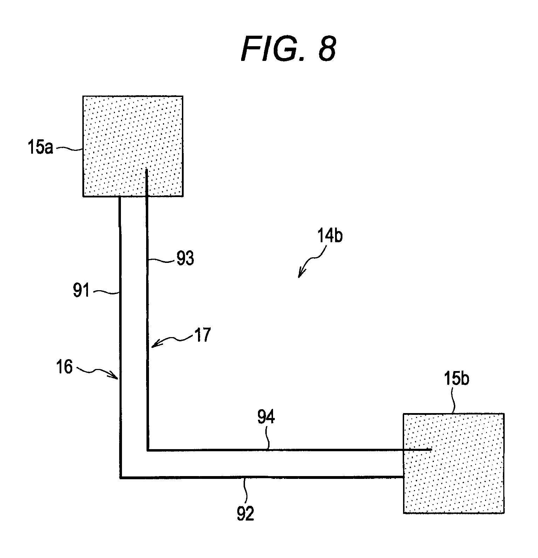

FIG. 8 schematically shows a structure of a printed wiring board 14b according to a third embodiment. In the printed wiring board 14b, a first wiring pattern 16 has a first wiring 91 connected to a first LSI chip package 15a at an end and a second wiring 92 connected to the other end of the first wiring 91 at an end and connected to a second LSI chip package 15b at the other end. The first wiring 91 and the second wiring 92 are disposed orthogonal to each other. That is, the first wiring 91 extends in parallel with warps 26. The second wiring 92 extends in parallel with wefts 27.

Likewise, a second wiring pattern 17 has a first wiring 93 connected to the first LSI chip package 15a at an end and a second wiring 94 connected to the other end of the first wiring 93 at an end and connected to the second LSI chip package 15b at the other end. The first wiring 93 and the second wiring 94 are disposed orthogonal to each other. That is, the first connection wiring 93 extends in parallel with the warps 26. The second wiring 94 extends in parallel with the wefts 27. The first wiring 93 extends in parallel with the first wiring 91 extend. The second wiring 94 extends in parallel with the second wiring 92.

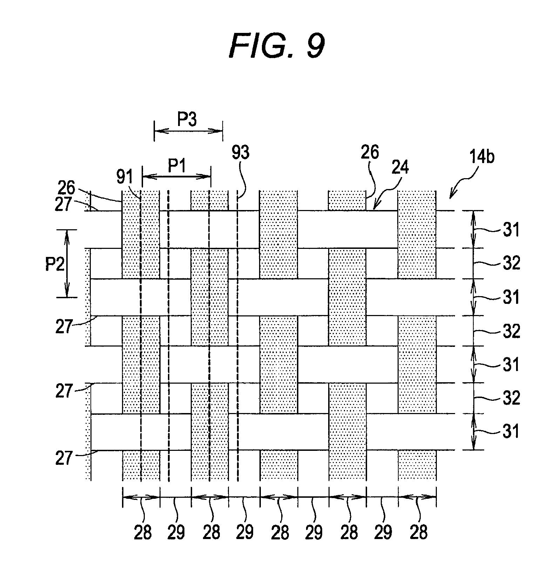

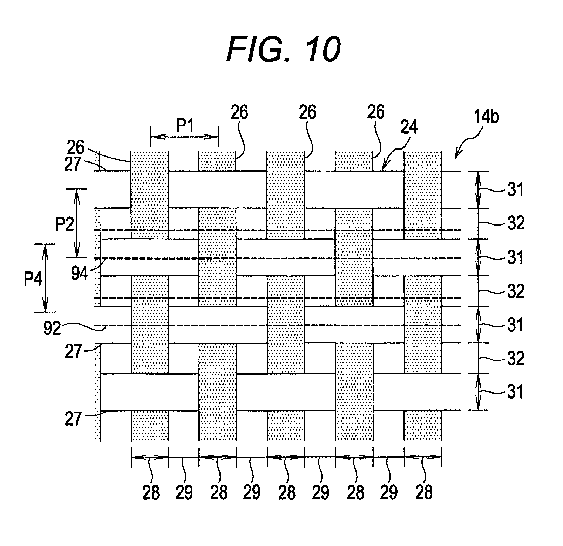

As shown in FIG. 9, the space P3 between the center line of the first wiring 91 and the center line of the first wiring 93 is set to an integral multiple of the space P1 described above. Here, the space P3 is set one time the space P1, i.e., set to the same as the space P1. Likewise, as shown in FIG. 10, the space P4 between the center line of the second wiring 92 and the center line of the second wiring 94 is set to an integral multiple of the space P2 described above. Here, the space P4 is set one time the space P2, i.e. set to the same as the space P2. Note that in the printed wiring board 14b, the width of the first region 28 (the first region 31) may not be set to the same as the width of the second region 29 (the second region 32). In addition to the above-mentioned, an arrangement and a structure that are the same as those of the printed wiring board 14 described above are denoted by the same reference numerals.

In the printed wiring board 14b described above, the space P3 (the space P4) is set to the same as the space P1 (the space P2). As a result, even if the first and second wiring patterns 16, 17 are disposed at any positions on the main body 23, the ratio of the first wiring 91 (the second wiring 92) disposed in the first region 28 (the first region 31) and the second region 29 (second region 32) agrees with the ratio of the first wiring 93 (the second wiring 94) disposed in the first region 28 (the first region 31) and the second region 29 (second region 32). As a result, the dielectric constant of the first wiring pattern 16 agrees with the dielectric constant of the second wiring pattern 17 over the entire lengths thereof. The dispersion of characteristic impedance is securely avoided between the first and second wiring patterns 16, 17. The disagreement of a transmission speed between the first and second wiring patterns 16, 17 is securely avoided. A differential signal can be correctly transmitted.

Although a few preferred embodiments of the present invention have been shown and described, it would be appreciated by those skilled in the art that changes may be made in these embodiments without departing from the principles of the invention, the scope of which is defined in the claims.

## Claims

1. A printed wiring board comprising:
a main body made of resin;
a plurality of glass fiber yarns which are woven, impregnated with resin of the main body, and disposed in parallel with each other with a predetermined width;
a pair of first wirings formed on a front surface of the main body and disposed in parallel with the glass fiber yarns;
a pair of second wirings formed on a front surface of the main body, disposed in parallel with the glass fiber yarns, and having the same length as the length of the first wirings corresponding thereto, respectively; and
a pair of connection wirings for individually connecting the first wiring and the second wiring corresponding thereto while being orthogonal to the glass fiber yarns,
wherein the glass fiber yarns adjacent to each other are separated at the same space as the width of the glass fiber yarns; and the center line of the first wiring and the center line of the second wiring corresponding thereto are separated at a space of (space between the center lines of the adjacent glass fiber yarns x 1/2 + space between the center lines of the adjacent glass fiber yarns x N (N is an integer of at least 0 (zero)).

2. A printed substrate unit comprising:
a main body made of resin;
a plurality of glass fiber yarns which are woven, impregnated with resin of the main body, and disposed in parallel with each other with a predetermined width;
a pair of first wirings formed on a front surface of the main body and disposed in parallel with the glass fiber yarns;
a pair of second wirings formed on a front surface of the main body, extending in parallel with the glass fiber yarns, and having the same length as the length of the first wirings corresponding thereto, respectively;
a pair of connection wirings for individually connecting the first wiring and the second wiring corresponding thereto while being orthogonal to the glass fiber yarns; and a pair of electronic parts connected to each other by the first wirings, the connection wirings, and the second wirings,
wherein the glass fiber yarns adjacent to each other are separated at the same space as the width of the glass fiber yarns; and the center line of the first wiring and the center line of the second wiring corresponding thereto are separated at a space of (space between the center lines of the adjacent glass fiber yarns x 1/2 + space between the center lines of the adjacent glass fiber yarns x N (N is an integer of at least 0 (zero)).

3. A printed wiring board comprising:
a main body made of resin;
a plurality of glass fiber yarns which are woven, impregnated with resin of the main body, and disposed in parallel with each other with a predetermined width;
each one pair of first to m-th wirings (m is an even number of at least two) formed on a front surface of the main body and extending in parallel with the glass fiber yarns; and
each one pair of first to p-th connection wirings (p is an odd number of at least 1) formed on a front surface of the main body for connecting an n-th wiring and an (n + 1)-th wiring (n is an integer of at least one) corresponding thereto individually while being orthogonal to the glass fiber yarns,
wherein the glass fiber yarns adjacent to each other are separated at the same space as the width of the glass fiber yarns,
the center line of an r-th wiring (r is an integer of at least 1) and the center line of an (r+1)-th wiring corresponding thereto are separated at a space of (space between the center lines of the adjacent glass fiber yarns x 1/2 + space between the center lines of the adjacent glass fiber yarns x N (N is an integer of at least 0 (zero)), and
the sum of the lengths of all the s-th wirings (s is an odd number of at least 1) is equal to the sum of the lengths of all the t-th wirings (t is an even number of at least two).

4. A printed substrate unit comprising:
a main body made of resin;
a plurality of glass fiber yarns which are woven, impregnated with resin of the main body, and disposed in parallel with each other with a predetermined width;
each one pair of first to m-th wirings (m is an even number of at least two) formed on a front surface of the main body and disposed in parallel with the glass fiber yarns; and
each one pair of first to p-th connection wirings (p is an odd number of at least 1) formed on a front surface of the main body for individually connecting an n-th wiring and an (n + 1)-th wiring (n is an integer of at least one) corresponding thereto while being orthogonal to the glass fiber yarns; and a pair of electronic parts connected to each other by a first to m-th wirings and a first to p-th connection wirings,
wherein the glass fiber yarns adjacent to each other are separated at the same space as the width of the glass fiber yarns; the center line of an r-th wiring (r is an integer of at least 1) and the center line of an (r+1)-th wiring corresponding thereto are separated at a space of (space between the center lines of the adjacent glass fiber yarns x 1/2 + space between the center lines of the adjacent glass fiber yarns x N (N is an integer of at least 0 (zero)), and
the sum of the lengths of all the s-th wirings (s is an odd number of at least 1) is equal to the sum of the lengths of all the t-th wirings (t is an even number of at least two).

5. A printed wiring board comprising:
a main body made of resin;
a plurality of glass fiber yarns which are woven, impregnated with resin of the main body, and extending in parallel with each other; and
a pair of wiring patterns extending in parallel with the glass fiber yarns and prescribing a center line at a space that is an integral multiple of the space between the center lines of the glass fiber yarns.

6. A printed substrate unit comprising:
a main body made of resin;
a plurality of glass fiber yarns which are woven, impregnated with resin of the main body, and extending in parallel with each other;
a pair of wiring patterns extending in parallel with the glass fiber yarns and prescribing a center line at a space that is an integral multiple of the space between the center lines of the glass fiber yarns; and
a pair of electronic parts connected to each other by the wiring patterns.
